(19) **Europäisches Patentamt**
**European Patent Office**
**Office européen des brevets**

(11) **EP 1 590 679 B1**

(12) **EUROPÄISCHE PATENTSCHRIFT**

(45) Veröffentlichungstag und Bekanntmachung des Hinweises auf die Patenterteilung:
**20.08.2008 Patentblatt 2008/34**

(51) Int Cl.:
*G01R 31/36* (2006.01)    *H02J 7/00* (2006.01)

(21) Anmeldenummer: **04706603.0**

(22) Anmeldetag: **30.01.2004**

(86) Internationale Anmeldenummer:
**PCT/DE2004/000144**

(87) Internationale Veröffentlichungsnummer:
**WO 2004/068157 (12.08.2004 Gazette 2004/33)**

(54) **ZUSTANDSGRÖSSEN- UND PARAMETERSCHÄTZER MIT MEHREREN TEILMODELLEN FÜR EINEN ELEKTRISCHEN ENERGIESPEICHER**

STATE VARIABLE AND PARAMETER ESTIMATOR COMPRISING SEVERAL PARTIAL MODELS FOR AN ELECTRICAL ENERGY STORAGE DEVICE

ESTIMATEUR DE VARIABLES D'ETAT ET DE PARAMETRES COMPRENANT PLUSIEURS MODELES PARTIELS POUR UN ACCUMULATEUR D'ENERGIE ELECTRIQUE

(84) Benannte Vertragsstaaten:
**DE FR GB**

(30) Priorität: **30.01.2003 DE 10303506**
**23.06.2003 DE 10328055**

(43) Veröffentlichungstag der Anmeldung:
**02.11.2005 Patentblatt 2005/44**

(73) Patentinhaber: **ROBERT BOSCH GMBH**
**70442 Stuttgart (DE)**

(72) Erfinder: **SCHOCH, Eberhard**
**70469 Stuttgart (DE)**

(56) Entgegenhaltungen:
EP-A- 1 271 170          WO-A-01/42799
WO-A-02/41014          WO-A-03/005052
US-A1- 2001 009 370

- **BAERT D ET AL: "Lead-acid battery model for the derivation of Peukert's law" ELECTROCHIMICA ACTA, ELSEVIER SCIENCE PUBLISHERS, BARKING, GB, Bd. 44, Nr. 20, 1. Juni 1999 (1999-06-01), Seiten 3491-3504, XP004168624 ISSN: 0013-4686**
- **SHEN W X ET AL: "Estimation of battery available capacity under variable discharge currents" JOURNAL OF POWER SOURCES, ELSEVIER SEQUOIA S.A. LAUSANNE, CH, Bd. 103, Nr. 2, 1. Januar 2002 (2002-01-01), Seiten 180-187, XP004312742 ISSN: 0378-7753**

EP 1 590 679 B1

**Beschreibung**

Die Erfindung betrifft ein Verfahren zum Bestimmen von Zustandsgrößen und Parametern eines mathematischen Energiespeichermodells, insbesondere eines Batteriemodells, gemäß dem Oberbegriff des Patentanspruchs 1, sowie einen Zustandsgrößen- und Parameterschätzer gemäß dem Oberbegriff des Patentanspruchs 9.

In elektrischen Netzen, wie beispielsweise Kfz-Bordnetzen, werden i.d.R. mehrere elektrische Verbraucher von einem elektrischen Energiespeicher, wie z.B. einer Batterie mit Leistung versorgt. Zur Durchführung eines Energie- und Verbrauchermanagements, bei dem Verbraucher je nach Bedarf automatisch zu- und abgeschaltet werden können, ist die Kenntnis der Leistungsfähigkeit des Energiespeichers von wesentlicher Bedeutung. Bei Kenntnis der Leistungsfähigkeit des Energiespeichers, insbesondere der noch entnehmbaren Ladung bis zur Unterschreitung einer geforderten Mindestleistungsfähigkeit z.B. für einen Motorstart, können noch vor Eintritt einer Unterversorgung verbrauchsmindernde oder leistungserhöhende Maßnahmen, wie z.B. das Abschalten bestimmter Verbraucher, eingeleitet und somit ein Ausfall der elektrischen Versorgung verhindert werden.

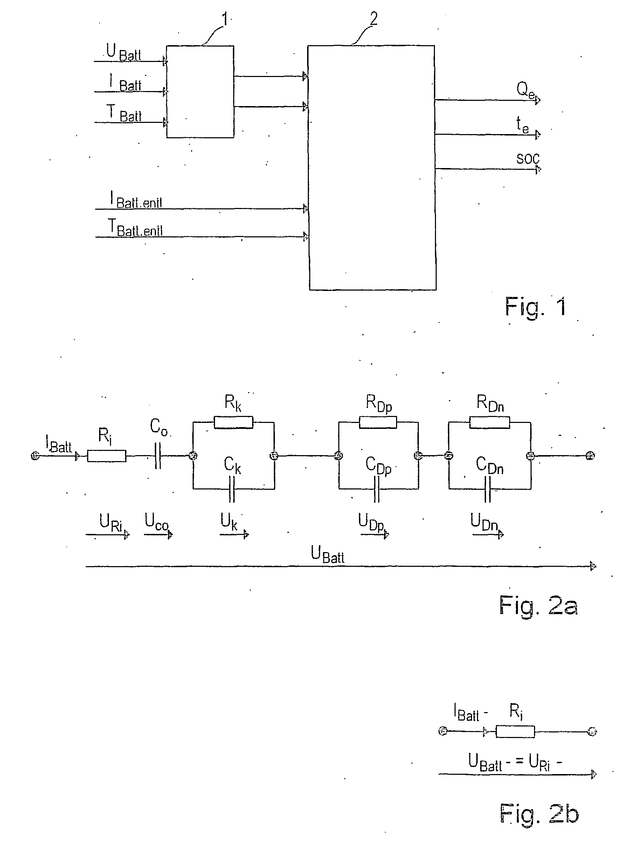

Zur Abschätzung der Leistungsfähigkeit des Energiespeichers, ist es bekannt, mathematische Modelle zu verwenden, welche die elektrischen Eigenschaften des Energiespeichers beschreiben. Mit Hilfe der mathematischen Modelle kann unter Berücksichtigung aktueller Betriebsgrößen des Energiespeichers, wie z.B. einer aktuellen Batteriespannung $U_{Batt}$, dem aktuellen Batteriestrom $I_{Batt}$ und der aktuellen Batterietemperatur $T_{Batt}$, die Leistungsfähigkeit des Energiespeichers abgeschätzt werden. Eine aus dem Stand der Technik bekannte Vorrichtung zur Bestimmung der aus einem Energiespeicher entnehmbaren Ladung ist in Fig. 1 dargestellt.

Fig. 1 zeigt eine Vorrichtung zur Bestimmung der aus einem Energiespeicher, insbesondere aus einer Fahrzeugbatterie, bis zu einem vorgegebenen Entladeschlusskriterium entnehmbaren Ladung. Die Vorrichtung umfasst einen Zustandsgrößen- und Parameterschätzer 1, sowie einen Ladungsprädiktor 2, in dem das mathematische Energiespeichermodell hinterlegt ist. Der Zustandsgrößen- und Parameterschätzer 1 dient dazu, aus den aktuellen Betriebsgrößen der Batterie, nämlich der Batteriespannung $U_{Batt}$, dem Batteriestrom $I_{Batt}$ und der Batterietemperatur $T_{Batt}$, Zustandsgrößen Z und/oder Parameter P zu berechnen, auf deren Grundlage der Ladungsprädiktor 2 die gewünschte Information, wie z.B. die aus der Batterie entnehmbare Ladung $Q_e$, oder andere Größen, wie beispielsweise die Zeit $t_e$ bis zum Erreichen eines Entladeschlusskriteriums oder den Ladezustand SOC berechnet. Dem Ladungsprädiktor 2 kann ferner ein Entladestromverlauf $I_{Batt,Entl}$, sowie ein Temperaturverlauf $T_{Batt,Entl}$ zugeführt werden.

Als Zustandsgrößen Z gelten in dieser Beschreibung insbesondere interne Spannungen U, die sich aus dem jeweiligen Ersatzschaltbild des Energiespeichers bzw. dem zugrundeliegenden mathematischen Modell ergeben. Bei den genannten Parametern handelt es sich um konstante Werte, wie z.B. Widerstände R und Kapazitäten C im Ersatzschaltbild bzw. mathematischen Energiespeichermodell.

Die vom Ladungsprädiktor 2 durchgeführte Ladungsberechnung erfolgt ausgehend vom aktuellen Zustand des Energiespeichers. Die im Ladungsprädiktor 2 hinterlegten mathematischen Modelle werden daher zunächst auf den aktuellen Betriebszustand des Energiespeichers initialisiert. Hierzu liefert der Zustandsgrößen- und Parameterschätzer 1 die entsprechenden Anfangswerte. Als Zustandsgrößen- und Parameterschätzer kann beispielsweise ein bekanntes Kalman-Filter verwendet werden. Ausgehend vom Initialisierungszustand kann der Ladungsprädiktor 2 z.B. die aus dem Energiespeicher entnehmbare Ladung $Q_e$ für einen vorgegebenen Entladestrom und ein aktuelle Batterietemperatur berechnen.

Fig. 2 zeigt ein Beispiel eines Ersatzschaltbildes für den Entladebetrieb eines Bleiakkumulators ($I_{Batt} < 0A$, $U_{Dp} < 0V$, $U_{Dn} < 0V$). Die einzelnen Ersatzschaltbildgrößen sind dabei wie folgt, von links nach rechts:

| | |
|---|---|
| $R(U_{C0},U_e,T_{Batt})$ | Ohmscher Innenwiderstand, abhängig von der Ruhespannung $U_{C0}$, der Elektrolytspannung $U_e$ und der Säuretemperatur $T_{Batt}$ |
| $U_{Ri}$ | ohmscher Spannungsabfall |
| Co | Säurekapazität |
| $U_{C0}$ | Ruhespannung |
| $R_k(U_{C0}, T_{Batt})$ | Säurediffusionswiderstand, abhängig von der Ruhespannung $U_{c0}$ (Entladegrad) und der Säuretemperatur $T_{Batt}$ |
| $tau_k$ | $= R_k * C_k$ (Zeitkonstante der Säurediffusion) wird als konstant in der Größenordnung von 10min angenommen |
| $U_k$ | Konzentrationspolarisation |
| $U_e$ | $= U_{C0} + U_k$ (Elektrolytspannung) |
| $U_D (I_{Batt}, T_{Batt})$ | Stationäre Durchtrittspolarisation an der positiven Elektrode der Batterie ($U_{Dp}$) und der negativen Elektrode ($U_{Dn}$), abhängig vom Batteriestrom $I_{Batt}$ und der Säuretemperatur $T_{Batt}$ |
| $U_{Batt}$ | Klemmenspannung der Batterie |

Die einzelnen Ersatzschaltbildgrößen sind zurückzuführen auf verschiedene physikalische Effekte der Batterie, die dem Fachmann aus der einschlägigen Literatur bekannt sind.

Für den ohmschen Innenwiderstand $R_i$ kann beispielsweise folgende Beziehung angesetzt werden:

$$R_i(U_{C0}, U_e, T_{Batt}) = R_{i0}(T_{Batt}) * (1 + R_{I,fakt} * (U_{C0max} - U_{C0})/(U_e - U_{e,grenz})),$$

$$R_{i0}(T_{Batt}) = R_{i025}/(1+TK_{Lfakt}) * (T_{Batt} - 25°C))$$

dabei sind:

$R_{i025}$      ohmscher Innenwiderstand bei Vollladung und $T_{Batt}$ = 25 °C
$TK_{Lfakt}$      Temperaturkoeffizient des Batterieleitwerts
$R_{Ifakt}$      Kennfeldparameter
$U_{C0max}$      maximale Ruhespannung der vollgeladenen Batterie
$U_{e,grenz}$      Elektrolytspannung bei Entladeschluss (alterungsabhängig)

Für andere Ersatzschaltbildgrößen (z.B. $U_D$, $U_k$) umfasst der Ladungsprädiktor 2 entsprechend andere geeignete mathematische Ansätze. Das mathematische Modell des Energiespeichers umfasst wenigstens für den Innenwiderstand $R_i$, den Säurediffusionswiderstand $R_k$ und eine Durchtrittspolarisation $U_D$ mathematische Ansätze.

Die Zustandsgrößen liefern die Information über den Energieinhalt der Energiespeicher eines Systems. Sie entsprechen im Ersatzschaltbild den Spannungen an den Kapazitäten, also $U_{C0}$ und $U_k$. Zur modellbasierten Bestimmung der Leistungsfähigkeit des Energiespeichers müssen außer den Zustandsgrößen auch die Modell-Parameter bekannt sein. Insbesondere müssen stark alterungsveränderliche Parameter wie die Parameter $R_{i025}$ und $U_{e,grenz}$ der Kennlinie des ohmschen Innenwiderstands adaptiert werden.

Die vom Zustandsgrößen- und Parameterschätzer 1 ermittelten Zustandsgrößen Z und Parameter P können beispielsweise zur Bestimmung des Ladungszustands der Batterie, einer aktuellen oder zukünftigen Leistungsfähigkeit, sowie z.B. der aus dem Energiespeicher entnehmbaren Ladung genutzt werden.

Herkömmliche Prädiktoren (Schätzvorrichtungen), wie z.B. der in Fig. 1 gezeigte Ladungsprädiktor 2, umfassen meist sehr aufwändige Modelle mit vielen Zustandsgrößen und Parametern, die das Verhalten des Energiespeichers über einen großen Arbeitsbereich abdecken. Die Berechnung der Zustandsgrößen und Parameter ist dementsprechend aufwändig und kompliziert. Andere Prädiktoren umfassen dagegen einfache Modelle mit wenigen Zustandsgrößen und Parametern, die das Verhalten des Energiespeichers jedoch nur in bestimmten Arbeitspunkten oder bei bestimmten Frequenzen beschreiben.

Aus der WO 02/41014 A und der WO 03/005052 A sind verschiedene Verfahren zur Ermittlung der Zustandsgrößen und Parameter von Energiespeichern, beispielsweise von Bleiakkumulatoren in Kraftfahrzeugen bekannt. Diese Verfahren sind als modellbasierte Verfahren ausgestaltet, bei denen relativ einfache Modelle eingesetzt werden, die nur wenige Parameter und Zustandsgrößen umfassen, die das Verhalten des Energiespeichers nur in bestimmten Arbeitspunkten, beispielsweise bei der Entladung und/oder in bestimmten Frequenzbereichen, beispielsweise bei sehr niedrigen Frequenzen von < 1 Hz oder bei sehr hohen Frequenzen von mehr als 1 kHz beschreiben.

Es ist daher die Aufgabe der vorliegenden Erfindung, ein einfaches und schnelles Verfahren zur Abschätzung von Zustandsgrößen und/oder Parametern für ein mathematisches Energiespeichermodell zu schaffen, das im wesentlichen über den gesamten Arbeitsbereich und Frequenzbereich des Energiespeichers gültig ist.

Gelöst wird diese Aufgabe gemäß der Erfindung durch die in den Patentansprüchen 1 und 9 angegebenen Merkmale. Weitere Ausgestaltungen der Erfindung ergeben sich aus den Unteransprüchen.

Der wesentliche Gedanke der Erfindung besteht darin, im Zustandsgrößen- und Parameterschätzer mehrere mathematische Teilmodelle zur Abschätzung von Zustandsgrößen und/oder Parametern vorzusehen, die für unterschiedliche Arbeitsbereiche des Energiespeichers gelten. Die Arbeits- und/oder Frequenzbereiche der einzelnen Teilmodelle können sich dabei überlappen. Insgesamt decken die Teilmodelle im wesentlichen den gesamten Arbeitsbereich des Energiespeichers ab.

Somit ist eine kontinuierliche Schätzung von Zustandsgrößenund Parametern im gesamten Arbeits bereich des Energiespeichers möglich. Durch die Nutzung der erfindungsgemäßen Teilmodelle kann die Anzahl der zu schätzenden Zustandsgrößen und Parameter klein gehalten und damit die Gefahr einer mehrdeutigen Schätzung minimiert werden. Ferner ist durch die Aufteilung in Teilmodelle eine effektivere Nutzung der Prozessorleistung möglich: "Langsame" Teilmodelle mit großen Zeitkonstanten können unabhängig von "schnellen" Teilmodellen mit kleiner Abtastrate abgearbeitet werden.

Den Teilmodellen wird vorzugsweise ein Strom ($I_{Batt}$) oder eine Spannung ($U_{Batt}$) des Energiespeichers zugeführt, wobei der Strom ($I_{Batt}$) oder die Spannung ($U_{Batt}$) durch ein Filter auf den für das jeweilige Teilmodell gültigen Frequenzbereich dieser Betriebsgrößen des Energiespeichers eingeschränkt wird. Den Teilmodellen können somit Hochpass-, Tiefpass- oder Bandpassfilter vorgeschaltet sein.

Gemäß einer bevorzugten Ausführungsform der Erfindung wird ein Fehler zwischen einer Betriebsgröße ($U_{Batt}$, $I_{Batt}$) des Energiespeichers und einer von einem Teilmodell berechneten Betriebsgröße ($U_{Batt^}$, $I_{Batt^}$) ermittelt und in das jeweilige Teilmodell zurückgekoppelt (Selbstrückkopplung). Durch die Selbstrückkopplung können die zu berechnenden Zustandsgrößen und Parameter an den Ist-Zustand des Energiespeichers angepasst werden.

Wahlweise kann der Fehler auch in ein anderes Teilmodell rückgekoppelt werden (Fremdrückkopplung). Durch die Fremdrückkopplung können die Zustandsgrößen und Parameter, die von mehreren Teilmodellen gleichzeitig berechnet werden, gegeneinander abgeglichen werden.

Die Fehler, die einem Teilmodell durch Selbstrückkopplung oder Fremdrückkopplung zugeführt werden, werden vorzugsweise mit einem Gewichtungsfaktor gewichtet. Auf diese Weise kann die Empfindlichkeit eines Teilmodells gegenüber unterschiedlichen Fehlern eingestellt werden.

Zustandsgrößen und/oder Parameter, die von einem Teilmodell geschätzt wurden und auch in einem anderen Teilmodell enthalten sind, werden vorzugsweise auch dem anderen Teilmodell zugeführt. Dort können sie als Startwert, als Fixwert oder als Korrekturwert für die Schätzung dienen.

Gemäß einer bevorzugten Ausführungsform der Erfindung ist eine Stimulationsvorrichtung vorgesehen, mit der eine den Teilmodellen zugeführte Betriebsgröße (Strom oder Spannung) in einen für das Teilmodell gültigen Arbeits- oder Frequenzbereich gebracht werden kann.

Die Erfindung wird nachstehend anhand der beigefügten Zeichnungen beispielhaft näher erläutert. Es zeigen:

Fig. 1 eine aus dem Stand der Technik bekannte Vorrichtung zur Berechnung der aus einem Energiespeicher entnehmbaren Ladung.

Fig. 2a ein Ersatzschaltbild für einen Bleiakkumulator während eines Entladevorgangs bei niedrigen Frequenzen;

Fig. 2b ein Ersatzschaltbild für einen Bleiakkumulator bei hohen Frequenzen;

Fig. 3a den Aufbau eines Zustandsgrößen- und Parameterschätzers mit mehreren Teilmodellen gemäß einer ersten Ausführungsform der Erfindung und Figur 3b gemäß einer zweiten Ausführungsform der Erfindung;

Fig. 4 ein Flussdiagramm zur Darstellung der Funktion eines Stimulators; und

Fig. 5 den Aufbau eines Zustandsgrößen- und Parameterschätzers zur Berechnung des Innenwiderstands einer Batterie.

Bezüglich der Erläuterung der Fig. 1 und 2a wird auf die Beschreibungseinleitung verwiesen.

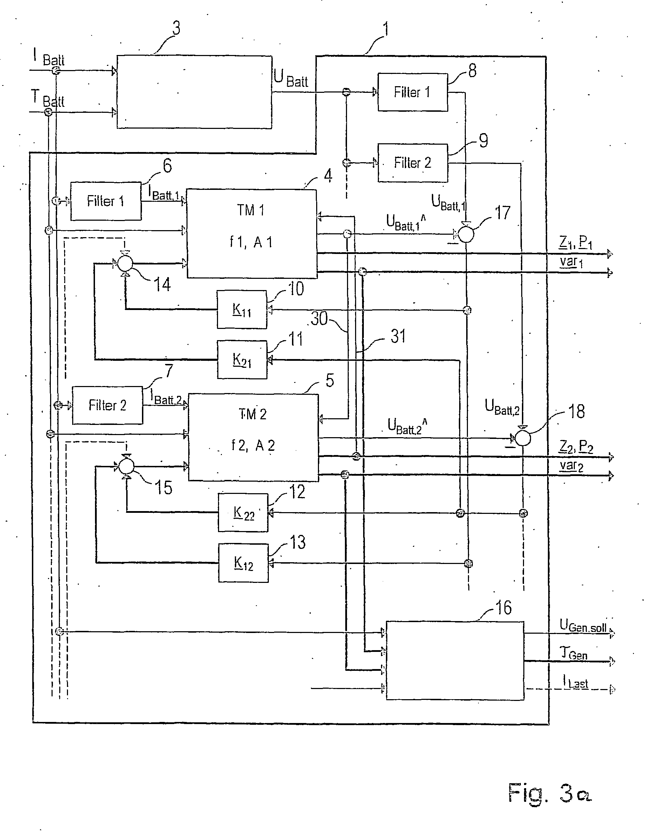

Fig. 3a zeigt den prinzipiellen Aufbau eines Zustandsgrößenund Parameterschätzers 1 gemäß einer ersten Ausführungsförm der Erfindung. Wie zu erkennen ist, umfasst der Zustandsgrößen- und Parameterschätzer 1 mehrere Teilmodelle 4, 5, die jeweils nur in einem bestimmten Frequenz- und/oder Arbeitsbereich (f1,A1 bzw. f2,A2) gelten und die dadurch sehr einfach gehalten werden können. Die Teilmodelle 4, 5 decken in ihrer Gesamtheit aber den gesamten Frequenz- und Arbeitsbereich des Energiespeichers 3 ab.

Die Frequenzbereiche f1,f2,... als auch die Arbeitsbereiche A1,A2,... können sich teilweise überlappen. Die Gesamtheit der Teilmodelle 4, 5 sollte im günstigsten Fall den gesamten, zumindest jedoch einen möglichst großen Arbeits- A und Frequenzbereich f des Energiespeichers abdecken.

Der Arbeitsbereich eines Teilmodells 4,5 wird durch vorgegebene Bedingungen für den Batteriestrom $I_{Batt}$, die Batteriespannung $U_{Batt}$, die Batterietemperatur $T_{Batt}$, Zustandgrößen Z und Batterieparameter P definiert.

Einzelne Zustandsgrößen Z und Parameter P können gleichzeitig in mehreren Teilmodellen 4, 5 auftreten und geschätzt werden.

Der in Fig. 1 dargestellte Zustandsgrößen- und Parameterschätzer 1 erhält an seinem Eingang kontinuierlich gemessene Batteriewerte, im vorliegenden Fall den Batteriestrom $I_{Batt}$ (wahlweise kann auch die Batteriespannung $U_{Batt}$ zugeführt werden) und die Batterietemperatur $T_{Batt}$. Der Batteriestrom $I_{Batt}$ wird durch geeignete Tiefpass-, Hochpassoder Bandpassfilter 6, 7, 8, 9 jeweils auf den Frequenzbereich f1, f2 eingeschränkt, in dem das jeweilige Teilmodell 4, 5 gültig ist. Ein Teilmodell 4, 5 (z.B. das Teilmodell 4), das z.B. in einem Frequenzbereich f1 von mehr als 1 kHz gültig ist, hat im vorliegenden Fall einen vorgeschalteten Hochpassfilter 6. Dem Teilmodell 5 kann z.B. ein Tiefpassfilter 7, 9 vorge-

4

schaltet sein. Deckt ein Teilmodell 4, 5 den gesamten Frequenzbereich f ab, können die Eingangsfilter 6, 9 für Strom und Spannung entfallen.

Die Teilmodelle 4, 5 berechnen aus den zugeführten Größen jeweils eine Batterie-Zustandsgröße ($I_{Batt^\wedge}$ oder $U_{Batt^\wedge}$). Der entsprechende Istwert ($I_{Batt}$ oder $U_{Batt}$) wird dem Zustandsgrößen- und Parameterschätzer 1 als Messwert von außen zugeführt. Die Schätzwerte $U_{Batt,1^\wedge}$, $U_{Batt,2^\wedge}$ bzw. daraus abgeleitete Größen (Fehlersignale) werden in das jeweilige Teilmodell 4, 5 rückgekoppelt.

Der Zustandsgrößen- und Parameterschätzer 1 umfasst Differenzknoten 17, 18, an denen ein Fehler (Differenzsignal) aus der geschätzten Batterie-Zustandsgröße $U_{Batt,1^\wedge}$, $U_{Batt,2^\wedge}$ und der jeweils gemessenen Batterie-Zustandsgröße $U_{Batt,1}$, $U_{Batt,2}$ gebildet wird. Die ermittelten Fehler ($U_{Batt,1} - U_{Batt,1^\wedge}$, $U_{Batt,2} - U_{Batt,2^\wedge}$,....) werden dann jeweils einer Gewichtungseinheit 10, 12 zugeführt und an Addierknoten 14, 15 geleitet.

Bei der Fehlerrückkopplung kann zwischen Selbstrückkopplung und Fremdrückkopplung unterschieden werden. Im ersteren Fall wird der Schätzfehler eines Teilmodells (4) dem selben Teilmodell (4) zugeführt, im anderen Fall wird der Schätzfehler eines Teilmodells (4) einem anderen Teilmodell (5) zugeführt. An den Addierknoten 14, 15 wird aus den einzelnen (gewichteten) Schätzfehlern ein Gesamtfehler erzeugt und dem jeweiligen Teilmodell 4,5 zugeführt.

Eine Fremdrückkopplung wird vorzugsweise nur dann realisiert, wenn bestimmte Zustandsgrößen Z oder Parameter P parallel in mehreren Teilmodellen auftreten. In diesem Fall können die Zustandsgrößen Z und Parameter P mit den anderen Teilmodellen abgeglichen werden.

Für eine Zustandsgröße $Z_{1,j}$ im j-ten Teilmodell, die außerdem in den Teilmodellen i = j+1, ..., j+n vorkommt, ergibt sich folgende Differenzengleichung:

$$Z_{1,j,k+1} = f(Z_{j,k},\ P_{j,k},\ I_{Batt,j,k},\ T_{Batt,k}) + \sum_{i=j...n} k_{z1,i,j}\ *\ (U_{Batt,i,k} - U_{Batt,i,k^\wedge})$$

Dabei ist $f(Z_{j,x}, P_{j,k}, I_{Batt,j,k}, T_{Batt,k})$ die rechte Seite einer Zustandsdifferenzengleichung für die Zustandsgröße $Z_{1,j}$ des j-ten Teilmodells mit den Eingangsgrößen: Gefilterter Batteriestrom $I_{Batt,j,k}$ und Batterietemperatur $T_{Batt,k}$ sowie dem Parametervektor $P_{j,k}$ im k-ten Zeitschritt.

Für einen konstanten Parameter $P_{1,j}$ im j-ten Teilmodell, der außerdem in den Teilmodellen i = j+1, ..., j+n vorkommt, ergibt sich:

$$P_{1,j,k}+1 = P_{1,j,k} + \sum_{i=j...n} k_{P1,i,j}\ *\ (U_{Batt,i,k} - U_{Batt,i,k^\wedge})$$

Die Verstärkungen $k_{i,j}$ der Gewichtungseinheiten 10-13 können bei einem Teilmodell 4, 5 entsprechend einem Luneberger-Beobachter durch Polvorgabe und bei Verwendung eines Kalman-Filters für die Teilmodelle 4, 5 durch Minimierung eines Gütekriteriums, wie z.B. der minimalen Schätzfehlervarianz, ermittelt werden.

Wenn sich der aktuelle Arbeitsbereich und/oder Frequenzbereich außerhalb des gültigen Arbeits- und/oder Frequenzbereichs eines Teilmodells 4, 5 befindet, darf keine Fehlerrückkopplung von einem solchen Teilmodell (z.B. Teilmodell 5) zu einem anderen Teilmodell erfolgen. Daher werden in einem solchen Fall vorzugsweise die Gewichtungsfaktoren $k_{i,j}$ der entsprechenden Gewichtungseinheiten (z.B. Gewichtungseinheit 11) auf Null gesetzt. Das heißt, $k_{i,j} = 0$, falls der Arbeitsbereich des i-ten Teilmodells verlassen wird.

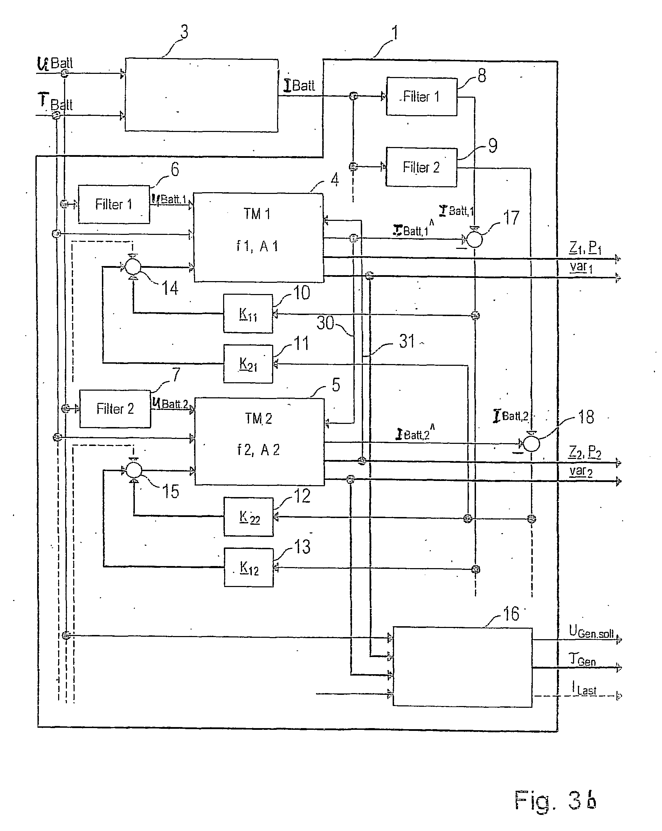

Bei der in Fig. 3a dargestellten Anordnung wird dem Zustandsgrößen- und Parameterschätzer 1 der Batteriestrom $I_{Batt}$ zugeführt. Gemäß einer anderen Ausführungsform nach Fig. 3b kann den Teilmodellen 4, 5 auch eine (gefilterte) Batteriespannung $U_{Batt}$ als Eingangsgröße zugeführt werden. Die Teilmodelle 4, 5 würden in diesem Fall einen Batteriestrom $I_{Batt^\wedge}$ abschätzen. Der Abgleich der Teilmodelle erfolgt über die Batteriespannung $U_{Batt,1}$, $U_{Batt,2}$,..., über die Batterieströme $I_{Batt,1}$,$I_{Batt,2}$,..., wenn die Batteriespannung als Eingangsgröße und der Batteriestrom als Ausgangsgröße der Teilmodelle definiert wird.

Zustandsgrößen und/oder Parameter, die von einem Teilmodell (4) geschätzt wurden und auch in einem anderen Teilmodell (5) enthalten sind, werden vorzugsweise auch dem anderen Teilmodell (5) zugeführt. Hierzu sind Verbindungsleitungen 30,31 vorgesehen. Im anderen Teilmodell (5) können die Werte als Startwert, als Fixwert oder als Korrekturwert für die Schätzung dienen.

Die Teilmodelle 4, 5 liefern neben den Zustandsgrößen Z und Parametern P auch die Fehlervarianzen ($var_1$,

var$_2$, ...) der Größen. Damit kann z.B. beurteilt werden, ob die Genauigkeit der Schätzgrößen Z, P für nachfolgende Berechnungen des Ladezustands, der Leistungsfähigkeit und/oder der aus der Batterie entnehmbaren Ladung ausreicht.

In einer weiteren Variante findet der Abgleich der Teilmodelle zusätzlich über die Batteriespannungen $U_{Batt,1}$, $U_{Batt,2}$,..., statt, d.h. die Stuktur nach Figur 3a oder 3b wird gleichzeitig zweimal benutzt, einmal mit nach der Batteriespannung und einmal mit nach dem Batteriestrom aufgelösten Teilmodellen. Die gleichzeitig geschätzten Zustandsgrößen und Parameter aus den einzelnen Teilmodellen der beiden Strukturen können dann z.B. gewichtet mit ihrer Fehlervarianz zu einer Schätzgröße verknüpft werden, entsprechend der bereits beschriebenen Weise zur Verknüpfung der in verschiedenen Teilmodellen parallel geschätzten Größen.

Zur optimalen Ausnutzung sämtlicher Teilmodelle 4, 5 sollten die Betriebsgrößen der Batterie 3 im Laufe der Berechnung sämtliche Arbeits- und Frequenzbereiche der Teilmodelle 4, 5 durchlaufen. Liefert das elektrische Netz, an dem die Batterie 3 angeschlossen ist, zu wenig Anregungen (z.B. Lastschwankungen), können die Größen nicht genau genug geschätzt werden. Sind die Anregungen im Netz gering, kann z.B. der Innenwiderstand $R_i$ der Batterie 3 nur sehr ungenau geschätzt werden. Bei geringer Anregung über einen längeren Zeitraum können insbesondere bei sicherheitskritischen Anwendungen Probleme auftreten, da keine genaue Aussage über die Leistungsfähigkeit der Batterie getroffen werden kann.

Der Zustandsgrößen- und Parameterschätzer 1 umfasst daher einen Stimulator 16, der in der Lage ist, aktiv in das elektrische Netz einzugreifen und den Arbeits- und/oder Frequenzbereich der Batterie 3 bzw. des Netzes in gewünschter Weise einzustellen. Der Stimulator 16 greift aktiv in das elektrische Netz ein, wenn die Fehlervarianz var vorgegebener Zustandsgrößen Z oder Parameter P für eine vorgegebene Zeitdauer zu groß ist. Dem Stimulator 16 werden die von den einzelnen Teilmodellen 4, 5 berechneten Varianzen var als Eingangsgrößen zugeführt.

Der Eingriff in das elektrische Netz durch den Stimulator 16 erfolgt z.B. durch Vorgabe einer neuen Generator-Sollspannung $U_{Gen,soll}$ (bei einem Fahrzeuggenerator), einer Load-Response-Zeitkonstanten $tau_{Gen}$ eines Generatorreglers und/oder durch geeignete Verbraucher-Zu- oder Abschaltung. Hierdurch kann ein für die Schätzung der jeweiligen Zustandsgröße Z oder des jeweiligen Parameters P geeigneter Batteriestromverlauf $I_{Batt}$, Spannungsverlauf $U_{Batt}$ und/oder Frequenzverlauf eingeprägt werden. Idealerweise wird der gewünschte Batteriestromverlauf $I_{Batt}$ (oder ein Spannungsverlauf $U_{Batt}$) so vorgegeben, dass er die Batterie 3 in einen Arbeitsbereich A überführt und in einem Frequenzbereich f anregt, in dem eines der Teilmodelle (z.B. Teilmodell 5) das die Schätzgröße enthält, besonders genau ist und somit die Schätzgröße sehr genau bestimmt werden kann. Dabei müssen natürlich der Abstand dieses neuen Arbeitsbereichs zum aktuellen Arbeitsbereich A der Batterie 3 und die maximal zulässigen Amplituden der Steuergrößen $U_{Gen,soll}$, $tau_{Gen}$, $I_{Last}$ sowie die maximal erlaubte Dauer des Steuereingriffs berücksichtigt werden.

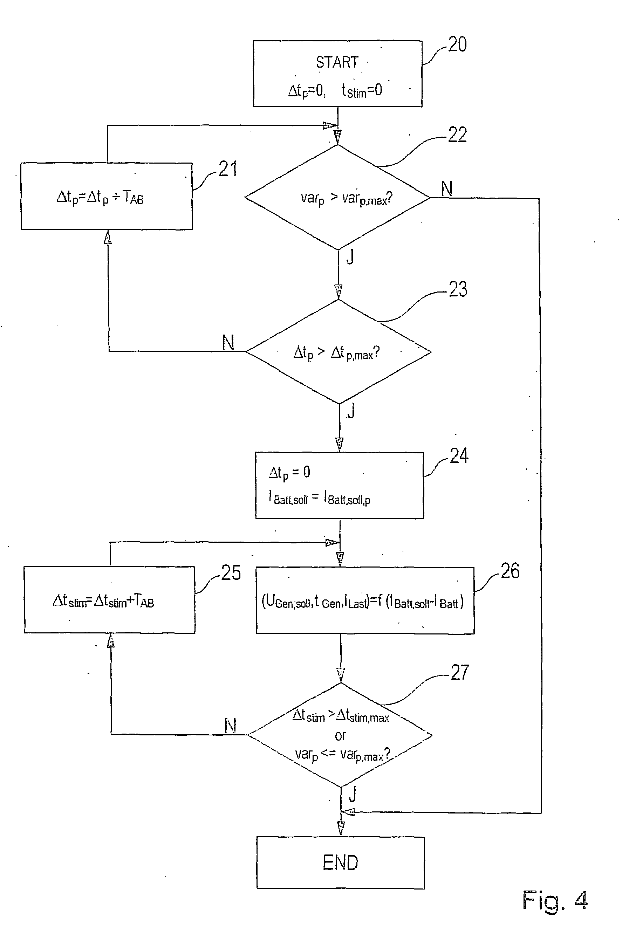

Die Arbeitsweise des Stimulators 16 von Fig. 1 ist beispielhaft in Fig. 4 dargestellt. Das Verfahren beginnt in Schritt 20 mit der Initialisierung der Zeiten tp und $t_{stim}$ auf die Werte tp = 0, $t_{stim}$ = 0. Dabei bezeichnet $t_p$ eine Zeit, in der ein Parameter P überwacht wird, und $t_{stim}$ eine Stimulationszeit.

In Schritt 22 wird überprüft, ob die Fehlervarianz var$_P$ größer ist als eine maximale Fehlervarianz var$_{p,max}$. Falls Nein (N) bleibt der Stimulator 16 deaktiviert. Bleibt die Fehlervarianz var$_p$ für eine Zeitdauer tp größer $t_{p,max}$ (Schritt 23) dagegen größer als var$_{p,max}$, wird ein dem Parameter P zugeordneter Stromverlauf $I_{Batt,soll,p}$ eingeprägt (Schritt 24 und 26). Dies erfolgt so lange, bis die Varianz var$_p$ des Parameters P kleiner oder gleich der maximalen Varianz var$_{p,max}$ dieses Parameters P ist oder die Stimulationsdauer $t_{stim}$ größer ist als eine vorgegebene maximale Dauer $t_{stim,max}$ (Überprüfung in Schritt 27). Die Variable $t_{stim}$ für die Stimulationsdauer wird in Schritt 25 iterativ um jeweils eine Abtastperiode $T_{Ab}$ erhöht.

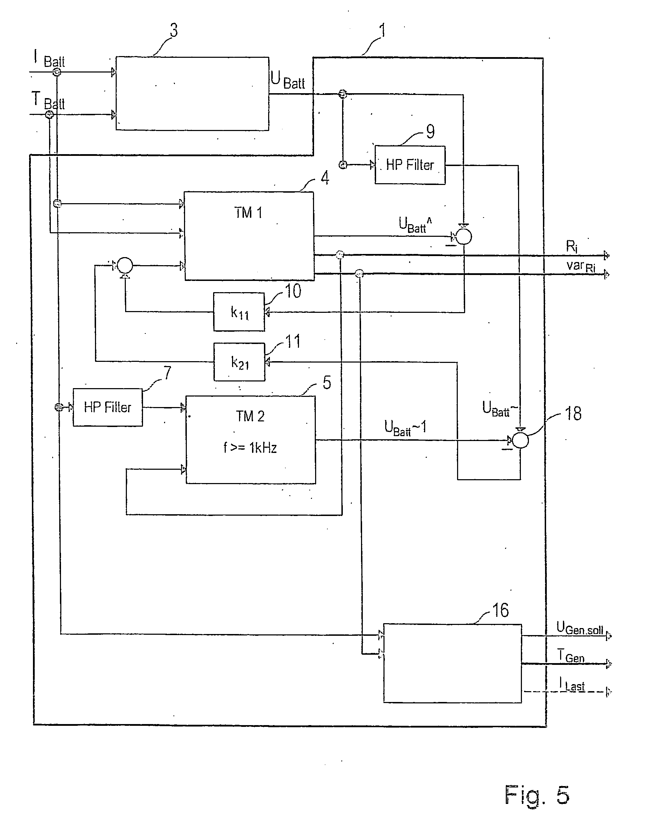

Fig. 5 zeigt eine spezielle Ausgestaltung eines Zustandsgrößen- und Parameterschätzers 1 zur Bestimmung des ohmschen Innenwiderstandes $R_i$ eines Bleiakkumulators 3. Der Innenwiderstand $R_i$ der Batterie 3 ist eine entscheidende Größe bei der Bestimmung eines Batteriezustands, wie z.B. der Leistungsfähigkeit der Batterie 3 oder der noch entnehmbaren Ladung.

Der Zustandsgrößen- und Parameterschätzer 1 umfasst zwei mathematische Teilmodelle 4, 5, von denen das erste Gültigkeit im gesamten Frequenzbereich hat und das zweite Teilmodell 5 nur bei Frequenzen größer gleich 1 kHz gültig ist. Entsprechend ist dem ersten Teilmodell 4 kein Filter und dem zweiten Teilmodell 5 ein Hochpassfilter 7 vorgeschaltet.

Das erste Teilmodell 4 umfasst eine mathematische Modellbeschreibung des Ersatzschaltbildes von Fig. 2a. Dagegen umfasst das zweite Teilmodell 5 eine mathematische Beschreibung des Ersatzschaltbildes von Fig. 2b, das im wesentlichen nur aus dem Innenwiderstand $R_i$ der Batterie 3 besteht. Beschränkt man sich nämlich auf einen Frequenzbereich in der Größenordnung von 1 kHz und betrachtet nur hochfrequente Wechselanteile von Strom $I_{Batt}$ und Spannung $U_{Batt}$, so können die Kapazitäten des Ersatzschaltbildes von Fig. 2a als kurzgeschlossen betrachtet werden. Die einzig verbleibende Komponente ist in diesem Fall der Innenwiderstand $R_i$ der Batterie.

Das erste Teilmodell 4 hat im folgenden Fall nur Gültigkeit für den Entladebetrieb, da sich der Innenwiderstand $R_i$ der Batterie 3 im Ladebetrieb nur schwer aus den wenigen Messgrößen Strom $I_{Batt}$, Spannung $U_{Batt}$ und Temperatur $T_{Batt}$ abschätzen lässt.

Für das erste Teilmodell 4, dem die Schätzfehler $U_{Batt} - U_{Batt^\wedge}$ bzw. $U_{Batts} - U_{Batts^\wedge}$ zugeführt werden, gilt:

$$R_{i,k+1} = R_{i,k} + k_{11}(U_{Batt} - U_{Batt\wedge}) + k_{21}(U_{Batt\sim} - U_{Batt\sim\wedge})$$

Für das zweite Teilmodell 5 gilt:

$$R_{i,k+1} = R_{i,k}$$

Der vom ersten Teilmodell 4 berechnete Wert für den Innenwiderstand $R_i$ der Batterie 3 wird dem zweiten Teilmodell 5 zugeführt und kann dort z.B. als Startwert verwendet werden. Die Gewichtungseinheiten für das zweite Teilmodell 5 mit den Gewichtungsfaktoren $k_{22}$ und $k_{12}$ können in diesem Fall entfallen. Die Gewichtungseinheiten 10,11 für die Fehlerrückkopplung in das Teilmodell 4 bleiben dagegen bestehen.

Es ist zu beachten, dass im Ladebetrieb der Gewichtungsfaktor $k_{11}$ auf Null zu setzen ist, da das erste Teilmodell 4 im Ladebetrieb nicht gültig ist. Die Gewichtungsfaktoren $k_{11}$ und $k_{21}$ können z.B. über einen Beobachterentwurf nach Luenberger oder Kalman bestimmt werden.

Bezugszeichenliste

| | |
|---|---|
| 1 | Zustandsgrößen- und Parameterschätzer |
| 2 | Ladungsprädiktor |
| 3 | Batterie |
| 4 | erstes Teilmodell |
| 5 | zweites Teilmodell |
| 6-9 | Filter |
| 10-13 | Gewichtungseinheiten |
| 14,15 | Addierknoten |
| 16 | Stimulator |
| 17,18 | Addierknoten |
| 20-27 | Verfahrensschritte |
| 30,31 | Verbindungsleitungen |

**Patentansprüche**

1. Verfahren zum Bestimmen von Zustandsgrößen und Parametern eines mathematischen Energiespeichermodells, insbesondere eines Batteriemodells, mit Hilfe eines Zustandsgrößen- und Parameterschätzers (1), der aus Betriebsgrößen ($U_{Batt}$, $I_{Batt}$, $T_{Batt}$) eines Energiespeichers (3) die Zustandsgrößen (Z) und Parameter (P) des mathematischen Energiespeichermodells berechnet, **dadurch gekennzeichnet, dass** der Zustandsgrößen- und Parameterschätzer (1) mehrere mathematische Teilmodelle (4, 5) umfasst, die jeweils derart für unterschiedliche Arbeitsbereiche des Energiespeichers (3) und Frequenzbereiche der Betriebsgrößen des Energiespeichers (3) gelten dass sie im wesentlichen den gesamten Frequenz- und Arbeitsbereich abdecken, wodurch eine kontinuierliche Schätzung der Zustandsgrößen und Parameter ermöglicht wird.

2. Verfahren nach Anspruch 1,
**dadurch gekennzeichnet, dass** den Teilmodellen (4, 5) ein Strom ($I_{Batt}$) oder eine Spannung ($U_{Batt}$) des Energiespeichers (3) zugeführt wird, wobei der Strom ($I_{Batt}$) oder die Spannung ($U_{Batt}$) durch ein Filter (6, 7) auf den für ein Teilmodell (4, 5) gültigen Frequenzbereich eingeschränkt wird.

3. Verfahren nach Anspruch 1 oder 2,
**dadurch gekennzeichnet, dass** ein Fehler zwischen einer Betriebsgröße ($U_{Batt}$, $I_{Batt}$) des Energiespeichers und einer von einem Teilmodell (4, 5) berechneten Betriebsgröße ($U_{Batt}$, $I_{Batt}$) ermittelt und in das jeweilige Teilmodell (4, 5) zurückgekoppelt wird.

**4.** Verfahren nach einem der vorhergehenden Ansprüche, **dadurch gekennzeichnet, dass** der Fehler zwischen einer Betriebsgröße ($U_{Batt}$, $I_{Batt}$) des Energiespeichers (3) und der von einem Teilmodell (4, 5) berechneten Betriebsgröße ($U_{Batt^}$, $I_{Batt^}$) in ein anderes Teilmodell (5) zurückgekoppelt wird.

**5.** Verfahren nach Anspruch 3 oder 4, **dadurch gekennzeichnet, dass** der Fehler mittels eines Faktors (k) gewichtet wird.

**6.** Verfahren nach einem der vorhergehenden Ansprüche, **dadurch gekennzeichnet, dass** eine von einem Teilmodell (4, 5) berechnete Zustandsgröße (Z) und/oder ein berechneter Parameter (P) einem anderen Teilmodell (5) zugeführt wird.

**7.** Verfahren nach Anspruch 6, **dadurch gekennzeichnet, dass** die Zustandsgrößen (Z) oder Parameter (P) gewichtet rückgekoppelt werden.

**8.** Verfahren nach einem der vorhergehenden Ansprüche, **dadurch gekennzeichnet, dass** ein Stimulator (16) vorgesehen ist, um den Strom ($I_{Batt}$) oder die Spannung ($U_{Batt}$), der bzw. die den Teilmodellen (4, 5) zugeführt wird, in einen gewünschten Arbeitsbereich oder Frequenzbereich zu bringen.

**9.** Zustandsgrößen- und Parameterschätzer (1) zum Bestimmen von Zustandsgrößen (Z) und Parametern (P) eines mathematischen Energiespeichermodells, insbesondere eines Batteriemodells, der aus Betriebsgrößen ($U_{Batt}$, $I_{Batt}$, $T_{Batt}$) eines Energiespeichers (3) die Zustandsgrößen (Z) und Parameter (P) des mathematischen Energiespeichermodells berechnet, **dadurch gekennzeichnet, dass** der Zustandsgrößen- und Parameterschätzer (1) mehrere Teilmodelle (4, 5) umfasst, die jeweils derart für unterschiedliche Arbeitsbereiche des Energiespeichers (3) und Frequenzbereiche der Betriebsgrößen des Energiespeichers (3) gelten dass sie im wesentlichen den gesamten Frequenz- und Arbeitsbereich abdecken, wodurch eine kontinuierliche Schätzung der Zustandsgrößen und Parameter ermöglicht wird.

**10.** Zustandsgrößen- und Parameterschätzer (1) nach Anspruch 9, **dadurch gekennzeichnet, dass** wenigstens einem der Teilmodelle (4, 5) ein Filter (6, 7) vorgeschaltet ist, um die dem Teilmodell (4, 5) zugeführte Betriebsgröße ($U_{Batt}$, $I_{Batt}$) des Energiespeichers (3) auf den für das Teilmodell (4, 5) gültigen Frequenzbereich einzuschränken.

**11.** Zustandsgrößen- und Parameterschätzer (1) nach Anspruch 9 oder 10, **dadurch gekennzeichnet, dass** der Betriebsgrößen- und Parameterschätzer (1) derart gestaltet ist, dass ein Fehler zwischen einer Betriebsgröße ($U_{Batt}$, $I_{Batt}$) des Energiespeichers (3) und einer von einem Teilmodell (4, 5) berechneten Betriebsgröße ($U_{Batt^}$, $I_{Batt^}$) ermittelt und in das jeweilige Teilmodell (4, 5) zurückgekoppelt wird.

**12.** Zustandsgrößen- und Parameterschätzer (1) nach einem der Ansprüche 9 bis 11, **dadurch gekennzeichnet, dass** der Betriebsgrößen- und Parameterschätzer (1) derart gestaltet ist, dass ein Fehler zwischen einer Betriebsgröße ($U_{Batt}$, $I_{Batt}$) des Energiespeichers (3) und einer von einem Teilmodell (4, 5) berechneten Betriebsgröße ($U_{Batt^}$, $I_{Batt^}$) in ein anderes Teilmodell (5) zurückgekoppelt wird.

**13.** Zustandsgrößen- und Parameterschätzer nach einem der Ansprüche 9 bis 12, **dadurch gekennzeichnet, dass** eine Einrichtung (10 - 13) zum Gewichten des rückgekoppelten Fehlers vorgesehen ist.

**14.** Zustandsgrößen- und Parameterschätzer (1) nach einem der Ansprüche 9 bis 13, **dadurch gekennzeichnet, dass** ein Stimulator (16) vorgesehen ist, um den Strom- oder Spannungsverlauf ($I_{Batt}$, $U_{Batt}$), der den Teilmodellen (4, 5) zugeführt wird, in einen gewünschten Arbeits- oder Frequenzbereich zu bringen.

**Claims**

**1.** Method for determination of state variables and parameters of a mathematical energy store model, in particular of a battery model, with the aid of a state variable and parameter estimator (1), which uses operating variables ($U_{Batt}$, $I_{Batt}$, $T_{Batt}$) of an energy store (3) to calculate the state variables (Z) and parameters (P) of the mathematical energy store model, **characterized in that** the state variable and parameter estimator (1) has a plurality of mathematical model elements (4, 5) which are each applicable to different operating ranges of the energy store (3) and frequency

EP 1 590 679 B1

ranges of the operating variables of the energy store (3) such that they essentially cover the entire frequency and operating range, thus allowing continuous estimation of the state variables and parameters.

**2.** Method according to Claim 1,
**characterized in that** the model elements (4, 5) are supplied with a current ($I_{Batt}$) or a voltage ($U_{Batt}$) of the energy store (3), with the current ($I_{Batt}$) or the voltage ($U_{Batt}$) being restricted by a filter (6, 7) to the frequency range applicable to a model element (4, 5).

**3.** Method according to Claim 1 or 2,
**characterized in that** an error between an operating variable ($U_{Batt}$, $I_{Batt}$) of the energy store and an operating variable ($U_{Batt}^\wedge$, $I_{Batt}^\wedge$) calculated by a model element (4, 5) is determined, and is fed back into the respective model element (4, 5).

**4.** Method according to one of the preceding claims,
**characterized in that** the error between an operating variable ($U_{Batt}$, $I_{Batt}$) of the energy store (3) and the operating variable ($U_{Batt^\wedge}$, $I_{Batt^\wedge}$) calculated by a model element (4, 5) is fed back into a different model element (5).

**5.** Method according to Claim 3 or 4,
**characterized in that** the error is weighted by means of a factor (k).

**6.** Method according to one of the preceding claims,
**characterized in that** a state variable (Z) calculated by a model element (4, 5) and/or a calculated parameter (P) are/is supplied to a different model element (5).

**7.** Method according to Claim 6,
**characterized in that** the state variables (Z) or parameters (P) are fed back with a weighting.

**8.** Method according to one of the preceding claims,
**characterized in that** a stimulator (16) is provided in order to change the current ($I_{Batt}$) or the voltage ($U_{Batt}$) which is supplied to the model elements (4, 5) to a desired operating range or frequency range.

**9.** State variable and parameter estimator (1) for determination of state variables (Z) and parameters (P) of a mathematical energy store model, in particular of a battery model, which uses operating variables ($U_{Batt}$, $I_{Batt}$, $T_{Batt}$) of an energy store (3) to calculate the state variables (Z) and parameters (P) of the mathematical energy store model,
**characterized in that** the state variable and parameter estimator (1) has a plurality of model elements (4, 5) which are each applicable to different operating ranges of the energy store (3) and frequency ranges of the operating variables of the energy store (3) such that they essentially cover the entire frequency and operating range, thus allowing continuous estimation of the state variables and parameters.

**10.** State variable and parameter estimator (1) according to Claim 9,
**characterized in that** at least one of the model elements (4, 5) is preceded by a filter (6, 7) in order to restrict the operating variable ($U_{Batt}$, $I_{Batt}$) which is supplied to the model element (4, 5) of the energy store (3) to the frequency range applicable to the model element (4, 5).

**11.** State variable and parameter estimator (1) according to Claim 9 or 10,
**characterized in that** the operating variable and parameter estimator (1) is designed such that an error between an operating variable ($U_{Batt}$, $I_{Batt}$) of the energy store (3) and an operating variable ($U_{Batt^\wedge}$, $I_{Batt^\wedge}$) calculated by a model element (4, 5) is determined, and is fed back into the respective model element (4, 5).

**12.** State variable and parameter estimator (1) according to one of Claims 9 to 11,
**characterized in that** the operating variable and parameter estimator (1) is designed such that an error between an operating variable ($U_{Batt}$, $I_{Batt}$) of the energy store (3) and an operating variable ($U_{Batt^\wedge}$. $I_{Batt^\wedge}$) calculated by a model element (4, 5) is fed back into a different model element (5).

**13.** State variable and parameter estimator according to one of Claims 9 to 12,
**characterized in that** a device (10 - 13) is provided for weighting the fed-back error.

**14.** State variable and parameter estimator (1) according to one of Claims 9 to 13,

**characterized in that** a stimulator (16) is provided in order to change the current or voltage profile ($I_{Batt}$, $U_{Batt}$) which is supplied to the model elements (4, 5) to a desired operating range or frequency range.

**Revendications**

1. Procédé pour déterminer des grandeurs d'état et des paramètres d'un modèle mathématique d'un accumulateur d'énergie notamment d'un modèle de batterie d'accumulateurs à l'aide d'un moyen d'évaluation (1) des grandeurs d'état et des paramètres, qui, partant des grandeurs de fonctionnement ($U_{Batt}$, $I_{Batt}$, $T_{Batt}$) d'un accumulateur d'énergie (3) calcule les grandeurs d'état (Z) et les paramètres (P) du modèle mathématique de l'accumulateur d'énergie, **caractérisé en ce que**
   le moyen d'évaluation (1) des grandeurs d'état et des paramètres comprend plusieurs modèles mathématiques partiels (4, 5) qui sont valables respectivement pour des plages de travail différentes de l'accumulateur d'énergie (3) et des plages de fréquence des paramètres de fonctionnement de l'accumulateur d'énergie (3) **en ce que** ces parties couvrent pratiquement toute la plage de fréquence et la plage de fonctionnement, permettant une évaluation continue des grandeurs d'état et des paramètres.

2. Procédé selon la revendication 1,
   **caractérisé en ce qu'**
   on applique un courant ($I_{Batt}$) ou une tension ($U_{Batt}$) de l'accumulateur d'énergie (3) aux modèles partiels (4, 5), l'intensité ($I_{Batt}$) ou la tension ($U_{Batt}$) étant limitée par un filtre (6, 7) à la plage des fréquences valables pour un modèle partiel (4, 5).

3. Procédé selon la revendication 1 ou 2,
   **caractérisé en ce qu'**
   on détermine une erreur entre une grandeur de fonctionnement ($U_{Batt}$, $I_{Batt}$) de l'accumulateur d'énergie et une grandeur de fonctionnement ($U_{Batt^\wedge}$, $I_{Batt^\wedge}$) calculée à partir d'un modèle partiel (4, 5) et on applique une réaction sur le modèle partiel (4, 5) respectif.

4. Procédé selon l'une des revendications précédentes,
   **caractérisé en ce qu'**
   on applique en réaction l'erreur entre une grandeur de fonctionnement ($U_{Batt}$, $I_{Batt}$) de l'accumulateur d'énergie (3) et la grandeur de fonctionnement ($U_{Batt^\wedge}$, $I_{Batt^\wedge}$) calculée à partir d'un modèle partiel (4, 5) pour l'appliquer à un autre modèle partiel (5).

5. Procédé selon la revendication 3 ou 4,
   **caractérisé en ce qu'**
   on pondère l'erreur à l'aide d'un coefficient (k).

6. Procédé selon l'une des revendications précédentes,
   **caractérisé en ce qu'**
   on applique une grandeur d'état (Z) calculée par un modèle partiel (4, 5) et/ ou un paramètre calculé (P) à un autre modèle partiel (5).

7. Procédé selon la revendication 6,
   **caractérisé en ce qu'**
   on applique en retour les grandeurs d'état (Z) ou les paramètres (P) après pondération.

8. Procédé selon l'une des revendications précédentes,
   **caractérisé par**
   un stimulateur (16) pour fournir le courant ($I_{Batt}$) ou la tension ($U_{Batt}$) à un ou aux modèles partiels (4, 5), pour les mettre dans une plage de travail ou une plage de fréquence souhaitées.

9. Moyen d'évaluation des grandeurs d'état et paramètres (1) pour déterminer des grandeurs d'état (Z) et des paramètres (P) d'un modèle mathématique d'accumulateur d'énergie notamment d'un modèle de batterie qui, partant des grandeurs de fonctionnement ($U_{Batt}$, $I_{Batt}$, $T_{Batt}$) d'un accumulateur d'énergie (3), calcule les grandeurs d'état (Z) et les paramètres (P) du modèle mathématique d'accumulateur d'énergie, **caractérisé en ce que**

le moyen d'évaluation de grandeurs d'état et de paramètres (1) comprend plusieurs modèles partiels (4, 5) valables chaque fois pour des plages de travail différentes de l'accumulateur d'énergie (3) et des plages de fréquence des grandeurs de fonctionnement de l'accumulateur d'énergie (3) de façon à couvrir pratiquement toute la plage des fréquences et la plage de travail, ce qui permet une évaluation continue des grandeurs d'état et des paramètres.

10. Moyen d'évaluation des grandeurs d'état et des paramètres (1) selon la revendication 9,
**caractérisé en ce qu'**
un filtre (6, 7) est prévu en amont d'au moins l'un des modèles partiels (4, 5) pour limiter les grandeurs de fonctionnement ($U_{Batt}$, $I_{Batt}$) appliquées au modèle partiel (4, 5) et correspondant à l'accumulateur d'énergie (3) à la plage de fréquence valable pour ce modèle partiel (4, 5).

11. Moyen d'évaluation des grandeurs d'état et des paramètres (1) selon la revendication 9 ou 10
**caractérisé en ce que**
le moyen d'évaluation des grandeurs de fonctionnement et des paramètres (1) est conçu pour déterminer une erreur entre une grandeur de fonctionnement ($U_{Batt}$, $I_{Batt}$) de l'accumulateur d'énergie (3) et une grandeur de fonctionnement ($U_{Batt^\wedge}$, $I_{Batt^\wedge}$) calculée à partir d'un modèle partiel (4, 5) et on applique cette erreur en réaction à chaque modèle partiel (4, 5).

12. Moyen d'évaluation des grandeurs d'état et des paramètres (1) selon l'une des revendications 9 à 11,
**caractérisé en ce que**
le moyen d'évaluation des grandeurs de fonctionnement et des paramètres est conçu pour qu'une erreur entre une grandeur de fonctionnement ($U_{Batt}$, $I_{Batt}$) de l'accumulateur d'énergie (3) et une grandeur de fonctionnement ($U_{Batt^\wedge}$, $I_{Batt^\wedge}$) calculée à partir d'un modèle partiel (4, 5) soit appliquée en réaction à un autre modèle partiel (5).

13. Moyen d'évaluation des grandeurs d'état et des paramètres (1) selon l'une des revendications 9 à 12,
**caractérisé par**
une installation (10-13) pour pondérer l'erreur appliquée en retour en réaction.

14. Moyen d'évaluation des grandeurs d'état et des paramètres (1) selon l'une des revendications 9 à 13,
**caractérisé par**
un stimulateur (16) pour mettre la courbe d'intensité ou de tension ($I_{Batt}$, $U_{Batt}$) appliquée au modèle partiel (4, 5) dans une plage de travail ou de fréquence souhaitée.

Fig. 1

Fig. 2a

Fig. 2b

Fig. 3a

Fig. 3b

Fig. 4

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 0241014 A
- WO 03005052 A